(19) Europäisches Patentamt
European Patent Office
Office européen des brevets

(11) **EP 2 701 478 A1**

(12) **EUROPÄISCHE PATENTANMELDUNG**

(43) Veröffentlichungstag:
**26.02.2014 Patentblatt 2014/09**

(51) Int Cl.:
*H05K 7/20* (2006.01)     *H05K 7/14* (2006.01)
*G01K 7/42* (2006.01)

(21) Anmeldenummer: **12180971.9**

(22) Anmeldetag: **20.08.2012**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **Siemens Aktiengesellschaft
80333 München (DE)**

(72) Erfinder:
• **Abert, Michael
  76474 Au (DE)**
• **Kort, Valentin
  76829 Landau (DE)**
• **Rottmann, Norbert
  76829 Landau (DE)**

(54) **Baugruppe für ein modulares Automatisierungsgerät**

(57)     Es wird eine Baugruppe für ein modulares Automatisierungsgerät vorgeschlagen, mit einem in einer Gehäusekapsel (3) der Baugruppe angeordneten Sensor zur Erfassung der Temperatur ($T_{erf}$) der Zuluft in der Gehäusekapsel (3), wobei die Zuluft durch Lufteintrittsöffnungen der Gehäusekapsel (3) über Bauelemente und schließlich durch Luftaustrittsöffnungen (4) der Gehäusekapsel (3) strömt, und mit einer Überwachungseinheit zur Auswertung der von dem Sensor erfassten Temperatur ($T_{erf}$). Mittels geeigneter Maßnahmen wird eine genauere Ermittlung der Zulufttemperatur ermöglicht.

FIG 1

EP 2 701 478 A1

**Beschreibung**

Die Erfindung betrifft eine Baugruppe für ein modulares Automatisierungsgerät, mit einem in einer Gehäusekapsel der Baugruppe angeordneten Sensor zur Erfassung der Temperatur der Zuluft in der Gehäusekapsel, wobei die Zuluft durch Lufteintrittsöffnungen der Gehäusekapsel über Bauelemente und schließlich durch Luftaustrittsöffnungen der Gehäusekapsel strömt, und mit einer Überwachungseinheit zur Auswertung der von dem Sensor erfassten Temperatur. Darüber hinaus betrifft die Erfindung ein modulares Automatisierungsgerät mit mehreren solcher Baugruppen.

Derartige Baugruppen sind aus dem Siemens-Katalog ST 70, Kapitel 5, Ausgabe 2011 bekannt. Die auf einen Träger montierbaren Baugruppen sind Bestandteil eines modularen Automatisierungsgerätes und weisen jeweils innerhalb einer Gehäusekapsel eine mit elektrischen und elektronischen Bauteilen versehene SMD-Leiterplatte auf. Die Entwärmung dieser Bauteile erfolgt im Wesentlichen durch Konvektion in der Art und Weise, dass Luft durch eine Öffnung auf der Unterseite der Gehäusekapsel, über die Bauteile und schließlich durch eine Öffnung auf der Oberseite der Gehäusekapsel strömt, wobei die durch das Gehäuse strömende Luft den Bauteilen Wärme entzieht. In vielen Fällen sind die Baugruppen für einen Einsatz in einer rauen Prozessumgebung bis zu einer vorgegebenen Umgebungstemperatur ausgelegt und es ist daher erforderlich, während des Betriebs des Automatisierungsgerätes die Zulufttemperatur in der jeweiligen Baugruppe zu kennen, um sicherzustellen, dass die Baugruppe in der für sie spezifizierten Umgebungstemperatur betrieben werden kann.

Um die Temperatur der Zuluft zu erfassen, weist die SMD-Leiterplatte einen SMD-Sensor auf, wobei für den Fall, dass die Temperatur einen Schwellwert erreicht oder übersteigt, eine Temperaturüberwachungseinheit einem Anwender einen Fehler anzeigt. Aufgrund der SMD-Bauweise wird zwar der Platzbedarf der Bauelemente auf der Leiterplatte verringert, nachteilig ist allerdings, dass die Verlustwärme der Baugruppe den SMD-Sensor im Hinblick auf eine genaue Erfassung der Zulufttemperatur störend beeinflusst. Beispielsweise verfälschen auf der Leiterplatte angeordnete Wärmequellen in Form von Transformatoren oder Feldeffekttransistoren das Messergebnis des SMD-Sensors, d. h. die durch den Sensor erfasste Zulufttemperatur weicht von der tatsächlichen Zulufttemperatur ab, wobei weitere durch benachbarte Baugruppen bewirkte störende Temperatureinflüsse die Abweichungen erhöhen.

Der Erfindung liegt daher die Aufgabe zugrunde, eine Baugruppe der eingangs genannten Art sowie ein modulares Automatisierungsgerät mit derartigen Baugruppen zu schaffen, welche bzw. welches eine genauere Auswertung der Zulufttemperatur ermöglicht.

Diese Aufgabe wird im Hinblick auf die Baugruppe durch die im kennzeichnenden Teil des Anspruchs 1 angegebenen, bezüglich des Automatisierungsgerätes durch die im Anspruch 4 angegebenen Maßnahmen gelöst.

Vorteilhaft ist, dass die Zulufttemperatur genauer ermittelt werden kann, indem Abweichungen von der Zulufttemperatur ermittelt und diese zur Korrektur der mittels des Sensors erfassten Zulufttemperatur berücksichtigt werden. Verfälschungen des Messergebnisses im Hinblick auf die Zulufttemperatur aufgrund von auf der Leiterplatte angeordneten Wärmequellen und/oder durch benachbarte Baugruppen bewirkte störende Temperatureinflüsse werden weitgehend vermieden, was bedeutet, dass diese Störungen im Rahmen der Ermittlung der tatsächlichen Zulufttemperatur weitgehend eliminiert bzw. kompensiert werden. Darüber hinaus sind keine zusätzlichen Fertigungskosten und kein zusätzlicher Installationsaufwand erforderlich, beispielsweise kann auf einen weiteren außerhalb der Baugruppe bzw. Gehäusekapsel angeordneten Sensor zur Erfassung einer Referenztemperatur verzichtet werden. Es ist lediglich eine einmalige Anpassung der Baugruppen-Firmware zu bewerkstelligen.

In der Überwachungseinheit ist für einen Leistungsparameter mindestens eine Referenzkurve hinterlegt, die für diesen einen Leistungsparameter die Abweichungen der erfassten Temperatur oder einer Referenztemperatur in Abhängigkeit der Aufwärmzeit oder einer Abkühlzeit der Baugruppe repräsentiert. Um gute Ergebnisse im Hinblick auf die zu ermittelnde Zulufttemperatur zu erzielen, ist es nicht zwingend erforderlich, für eine Vielzahl von erfassbaren Temperaturen, beispielweise von Temperaturen von 10°C bis 70°C , eine Vielzahl von Referenzkurven in der Überwachungseinheit zu hinterlegen. In einem praktischen Ausführungsbeispiel der Erfindung ist lediglich für drei Leistungsparameter jeweils eine Referenzkurve für eine Referenztemperatur von 60°C gewählt, weil sich zeigt, dass die Temperaturabweichungen in Abhängigkeit der Aufwärmzeit bzw. Betriebsdauer nach dem Einschalten der Baugruppe sich von den Abweichungen für Temperaturen von 5 bis 50°C nur unwesentlich unterscheiden.

Selbstverständlich kann für jeden Leistungsparameter und jede der erfassbaren Temperaturen in dem genannten Temperaturbereich von 10°C bis 70°C eine Referenzkurve in der Überwachungseinheit hinterlegt werden, um im Rahmen der Auswertung besonders gute Ergebnisse zu erzielen. Unter einem Leistungsparameter wird beispielsweise der Betrieb der Baugruppe in Voll-, Halb- oder Viertellast verstanden.

Mittels der im Anspruch 2 angegebenen Maßnahmen wird eine einfache Berechnung der Zulufttemperatur während der Aufwärmzeit der Baugruppe ermöglicht. Während dieser Aufwärmzeit wird die Baugruppe z. B. in Halb- oder Volllast betrieben. Dies bedeutet für den Fall, dass die Baugruppe als Quellenmodul bzw. als Stromversorgungsbaugruppe ausgebildet ist, dieses Modul bzw. diese Baugruppe 50 oder 100% seiner Nennleistung den weiteren Baugruppen bzw. Senkenmodulen bereitstellt bzw. abgibt; für den Fall, dass die Baugruppe als Senkenmodul bzw. als Strom aufnehmende Baugruppe ausgebildet ist, dieses Modul bzw. diese Baugruppe 50 oder 100% seines Leistungsbedarfs von einem Quellenmodul bzw. von einer Stromversorgungsbaugruppe bezieht.

Durch die im Anspruch 3 angegebenen Maßnahmen wird eine einfache Berechnung der Zulufttemperatur während der Abkühlzeit der Baugruppe ermöglicht. Während dieser Abkühlzeit versorgt eine als Quellenmodul bzw. als Stromversorgungsbaugruppe ausgebildete Baugruppe keine weiteren Baugruppen mit Energie bzw. eine als Senkenmodul bzw. als Strom aufnehmende ausgebildete Baugruppe zieht keinen Strom von diesem Quellenmodul bzw. dieser Stromversorgungsbaugruppe.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:

Figuren 1 und 2 Referenzkurven und
Figur 3 eine Baugruppe eines modularen Automatisierungsgerätes.

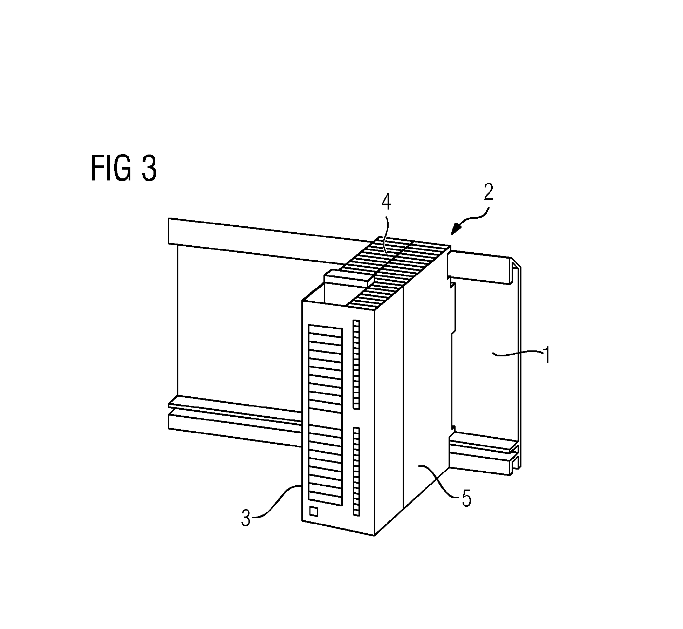

Es wird zunächst auf Figur 3 verwiesen, in welcher eine an sich bekannte, auf einem Träger 1 angeordnete Baugruppe 2 eines modularen, mehrere Baugruppen aufweisenden Automatisierungsgerätes dargestellt ist. Die Entwärmung erfolgt im Wesentlichen durch Konvektion in der Art und Weise, dass Zuluft durch Öffnungen (Lufteintrittsöffnungen) auf der Unterseite einer Gehäusekapsel 3 über die elektrischen und elektronischen Bauteile der Baugruppe und schließlich durch eine Öffnung 4 (Luftaustrittsöffnungen) auf der Oberseite der Gehäusekapsel 2 strömt, wobei die durch die Gehäusekapsel 3 strömende Luft den auf einer SMD-Leiterplatte angeordneten bzw. montierten Bauteilen Wärme entzieht. Die SMD-Leiterplatte ist gewöhnlich in der Gehäusekapsel 3 parallel zur Seitenwand 5 der Gehäusekapsel 3 positioniert bzw. angeordnet und weist einen SMD-Sensor zur Erfassung der Zulufttemperatur auf.

Um weitgehend zu vermeiden, dass auf der Leiterplatte angeordnete Wärmequellen und/oder störende Temperatureinflüsse von hier nicht dargestellten benachbarten Baugruppen das Messergebnis im Hinblick auf die Zulufttemperatur verfälschen, ist vorgesehen, mittels einer in einer Überwachungseinheit der Baugruppe hinterlegten Referenzkurve die Zulufttemperatur aus der erfassten Zulufttemperatur und einer zeitabhängigen Temperaturabweichung zu ermitteln. Diese Referenzkurve repräsentiert für einen Leistungsparameter die Abweichungen der erfassten Zulufttemperatur oder einer der erfassten Zulufttemperatur zugeordneten Referenztemperatur in Abhängigkeit einer Aufwärmzeit oder einer Abkühlzeit der Baugruppe. Mittels derartiger Maßnahmen werden die störenden Einflüsse im Rahmen der Auswertung der erfassten Zulufttemperatur berücksichtigt und weitgehend eliminiert.

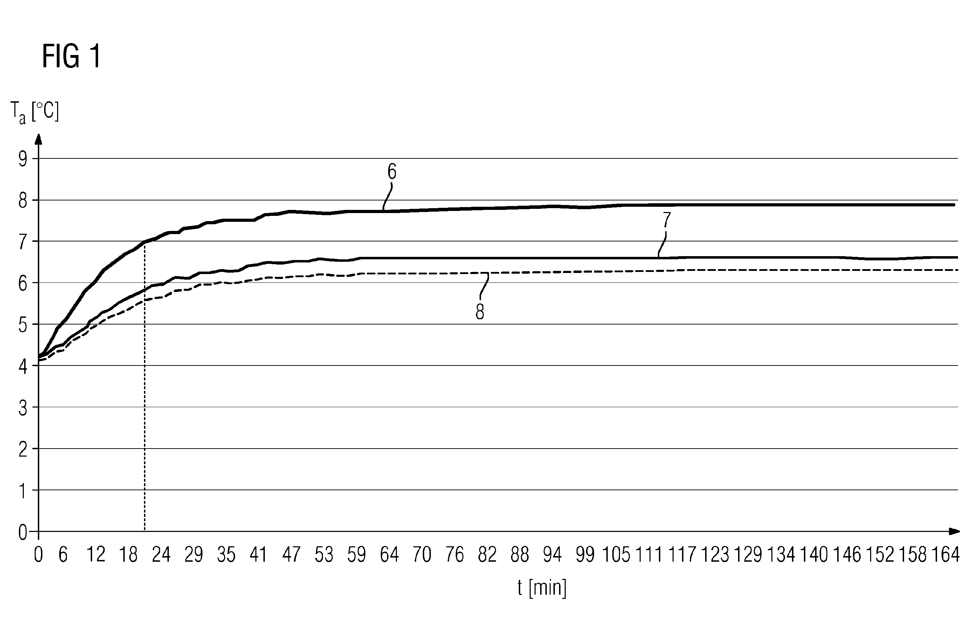

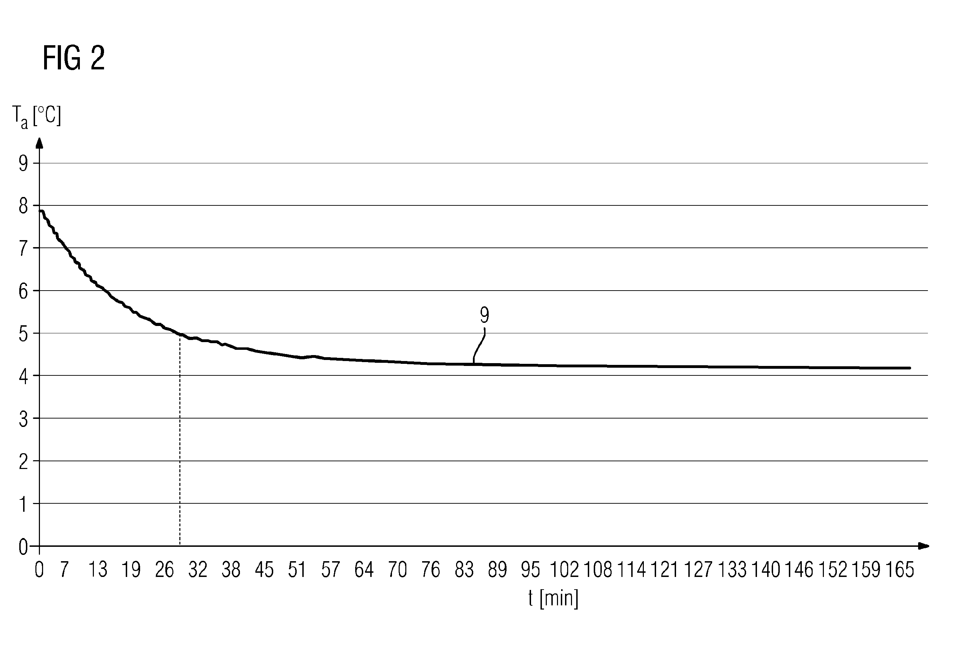

Zur näheren Erläuterung wird dazu im Folgenden auf Figuren 1 und 2 verwiesen, in welchen Referenzkurven dargestellt sind.

Figur 1 zeigt Referenzkurven 6 bis 8, welche Temperaturabweichungen $T_a$ in Abhängigkeit einer Aufwärmzeit $t_h$ einer Baugruppe im Volllast-, Halblast- sowie Viertellast-Betrieb darstellen, wobei als Referenztemperatur 60°C gewählt ist.

Für den Fall, dass z. B. der Sensor der Baugruppe eine Zulufttemperatur $T_{erf}$ von 50°C erfasst und die Baugruppe ca. 20 Minuten in Volllast im Betrieb ist, ermittelt eine Überwachungseinheit mittels der Referenzkurve 6 eine Temperaturabweichung $T_a$ von 7°C und berechnet aus der erfassten Zulufttemperatur $T_{erf}$ von 50°C und Temperaturabweichung $T_a$ von 7°C eine Zulufttemperatur $T_z$ von 43°C.

Allgemein gilt für die Temperaturabweichung $T_a$ während des Lastbetriebs bzw. der Aufwärmphase für $t>t_o$:

$$T_a = T_s + T_e \times (1 - e^{-\frac{t_h - t_0}{T}})$$

wobei bedeuten:

$t_h$: Aufwärmzeit,
$t_o$: Verzögerungs- bzw. Totzeit
$T$: Zeitkonstante (ca. 15 Minuten),
$T_z$: berechnete Zulufttemperatur,
$T_{erf}$: die erfasste Zulufttemperatur oder Referenztemperatur,
$T_a$: Temperaturabweichung,
$T_s$: empirisch ermittelte Temperaturabweichung zu Beginn der Aufwärmung und
$T_e$: empirisch ermittelte Temperaturabweichung zum Ende der Aufwärmung.

Für die Zulufttemperatur $T_z$ gilt allgemein:

$$T_z = T_{erf} - T_a$$

Im Folgenden wird auf Figur 2 verwiesen, welche eine Referenzkurve 9 zeigt, die Temperaturabweichungen $T_a$ in Abhängigkeit einer Abkühlzeit $t_k$ einer Baugruppe nach einem Volllast-Betrieb darstellt. In diesem Zustand nimmt die Baugruppe, z. B. eine Digitalausgabebaugruppe, nicht mehr an der Prozesssteuerung teil, die Überwachungseinheit ist allerdings weiterhin aktiv geschaltet. Für den Fall, dass die Baugruppe als Stromversorgungsbaugruppe ausgebildet ist, ist diese im Hinblick auf eine Leistungsabgabe passiv geschaltet. Auch in diesem Fall ist die Überwachungseinheit noch aktiv.

Für den Fall, dass z. B. der Sensor der Baugruppe während des Betriebs der Baugruppe eine Zulufttemperatur $T_{erf}$ von 50°C erfasst und die Baugruppe ca. 28 Minuten außer Betrieb ist, ermittelt eine Überwachungseinheit mittels der Referenzkurve 9 eine Temperaturabweichung $T_a$ von 5°C und berechnet aus der erfassten Zulufttemperatur $T_{erf}$ von 50°C und Temperaturabweichung $T_a$ von 5°C eine Zulufttemperatur $T_z$ von 45°C.

Allgemein gilt für die Temperaturabweichung $T_a$ während der Deaktivierung bzw. Abkühlphase für $t > t_o$:

$$T_a = T_{ss} + T_{ee} \times e^{-\frac{t_k - t_0}{T}} \qquad (4)$$

und wobei bedeuten:

$t_k$:     Abkühlzeit,
$t_o$:     Verzögerungs- bzw. Totzeit
$T$:     Zeitkonstante,
$T_z$:     berechnete Zulufttemperatur,
$T_{erf}$:     die erfasste Zulufttemperatur oder Referenztemperatur,
$T_a$:     Temperaturabweichung,
$T_{ss}$:     empirisch ermittelte Temperaturabweichung zu Beginn der Abkühlung, welche der empirisch ermittelte Temperaturabweichung $T_e$ zum Ende der Aufwärmung entspricht und
$T_{ee}$:     empirisch ermittelte Temperaturabweichung zum Ende der Abkühlung.

Für die Zulufttemperatur $T_z$ gilt wiederum allgemein:

$$T_z = T_{erf} - T_a$$

Die Erfindung lässt sich damit wie folgt zusammenfassen:

Eine Baugruppe für ein modulares Automatisierungsgerät, mit einem in einer Gehäusekapsel (3) der Baugruppe angeordneten Sensor zur Erfassung der Temperatur ($T_{erf}$) der Zuluft in der Gehäusekapsel (3), wobei die Zuluft durch Lufteintrittsöffnungen der Gehäusekapsel (3) über Bauelemente und schließlich durch Luftaustrittsöffnungen (4) der Gehäusekapsel (3) strömt, und mit einer Überwachungseinheit zur Auswertung der von dem Sensor erfassten Temperatur ($T_{erf}$), zeichnet sich dadurch aus, dass in der Überwachungseinheit mindestens eine Referenzkurve hinterlegt ist, welche für mindestens einen Leistungsparameter die Abweichungen der erfassten Temperatur ($T_{erf}$) oder einer der erfassten Temperatur ($T_{erf}$) zugeordneten Referenztemperatur in Abhängigkeit einer Aufwärmzeit oder einer Abkühlzeit der Baugruppe repräsentiert, wobei die Überwachungseinheit dazu ausgebildet ist, mittels der Referenzkurve die Zulufttemperatur ($T_z$) aus der erfassten Zulufttemperatur ($T_{erf}$) oder der Referenztemperatur und der zeitabhängigen Temperaturabweichung ($T_a$) zu ermitteln.

Mittels derartiger Maßnahmen wird eine genauere Ermittlung der Zulufttemperatur $T_z$ ermöglicht.

**Patentansprüche**

1. Baugruppen für ein modulares Automatisierungsgerät, mit einem in einer Gehäusekapsel (3) der Baugruppe angeordneten Sensor zur Erfassung der Temperatur ($T_{erf}$) der Zuluft in der Gehäusekapsel (3), wobei die Zuluft durch Lufteintrittsöffnungen der Gehäusekapsel (3) über Bauelemente und schließlich durch Luftaustrittsöffnungen (4) der Gehäusekapsel (3) strömt, und mit einer Überwachungseinheit zur Auswertung der von dem Sensor erfassten Temperatur ($T_{erf}$), **dadurch gekennzeichnet, dass** in der Überwachungseinheit mindestens eine Referenzkurve hinterlegt ist, welche für mindestens einen Leistungsparameter die Abweichungen der erfassten Temperatur ($T_{erf}$) oder einer der erfassten Temperatur ($T_{erf}$) zugeordneten Referenztemperatur in Abhängigkeit einer Aufwärmzeit oder einer Abkühlzeit der Baugruppe repräsentiert, wobei die Überwachungseinheit dazu ausgebildet ist, mittels der Referenzkurve die Zulufttemperatur ($T_z$) aus der erfassten Zulufttemperatur ($T_{erf}$) oder der Referenztemperatur und der zeitabhängigen Temperaturabweichung ($T_a$) zu ermitteln.

2. Baugruppe nach Anspruch 1, **dadurch gekennzeichnet, dass** die Überwachungseinheit dazu ausgebildet ist, während der Aufwärmzeit der Baugruppe die Zulufttemperatur ($T_z$) aus der erfassten Zulufttemperatur ($T_{erf}$) oder der Referenztemperatur und der Temperaturabweichung ($T_a$) gemäß der Beziehung

$$T_z = T_{erf} - T_a \qquad (1)$$

zu berechnen,
wobei für $t > t_o$ gilt

$$T_a = T_s + T_e \times (1 - e^{-\frac{t_k - t_0}{T}}) \qquad (2)$$

und wobei bedeuten:

$t_h$: Aufwärmzeit,
$t_o$: Verzögerungs- bzw. Totzeit
T: Zeitkonstante,
$T_z$: berechnete Zulufttemperatur,
$T_{erf}$: die erfasste Zulufttemperatur oder Referenztemperatur,
Ta: Temperaturabweichung,
$T_s$: die Temperaturabweichung zu Beginn der Aufwärmung und
$T_e$: die Temperaturabweichung zum Ende der Aufwärmung.

3.  Baugruppe nach Anspruch 1, **dadurch gekennzeichnet, dass** die Überwachungseinheit ferner dazu ausgebildet ist, während der Abkühlzeit die Zulufttemperatur ($T_z$) aus der erfassten Zulufttemperatur ($T_z$) oder der Referenztemperatur und der Temperaturabweichung ($T_a$) gemäß der Beziehung

$$T_z = T_{erf} - T_a \qquad\qquad (3)$$

zu berechnen,
wobei für $t > t_0$ gilt

$$T_a = T_{ss} + T_{ee} \times e^{-\frac{t_k - t_0}{T}} \qquad\qquad (4)$$

und wobei bedeuten:

$t_k$: Abkühlzeit,
$t_o$: Verzögerungs- bzw. Totzeit
T: Zeitkonstante,
$T_z$: berechnete Zulufttemperatur,
$T_{erf}$: die erfasste Zulufttemperatur oder Referenztemperatur,
Ta: Temperaturabweichung,
$T_{ss}$: die Temperaturabweichung zu Beginn der Abkühlung und
$T_{ee}$: die Temperaturabweichung zum Ende der Abkühlung.

4.  Modulares Automatisierungsgerät mit mehreren auf einem Träger angeordneten Baugruppen nach einem der Ansprüche 1 bis 3.

FIG 1

EP 2 701 478 A1

FIG 2

FIG 3

EP 2 701 478 A1

Europäisches Patentamt
European Patent Office
Office européen des brevets

**EUROPÄISCHER RECHERCHENBERICHT**

Nummer der Anmeldung

EP 12 18 0971

**EINSCHLÄGIGE DOKUMENTE**

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 101 47 946 A1 (SIEMENS AG [DE]) 30. April 2003 (2003-04-30) * das ganze Dokument * ----- | 1-4 | INV. H05K7/20 H05K7/14 G01K7/42 |
| A | US 2009/312999 A1 (KASZTENNY BOGDAN Z [CA] ET AL) 17. Dezember 2009 (2009-12-17) * das ganze Dokument * ----- | 1-4 | |
| A | DE 198 52 080 C1 (TRW AUTOMOTIVE ELECTRON & COMP [DE]) 17. August 2000 (2000-08-17) * das ganze Dokument * ----- | 1-4 | |
| A | DE 10 2008 056846 A1 (INFINEON TECHNOLOGIES AG [DE]) 4. Juni 2009 (2009-06-04) * das ganze Dokument * ----- | 1-4 | |

RECHERCHIERTE SACHGEBIETE (IPC)

H05K
G01K
G05B

Der vorliegende Recherchenbericht wurde für alle Patentansprüche erstellt

| Recherchenort | Abschlußdatum der Recherche | Prüfer |
|---|---|---|
| Den Haag | 12. Februar 2013 | Kaluza, Andreas |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................

& : Mitglied der gleichen Patentfamilie, übereinstimmendes Dokument

EPO FORM 1503 03.82 (P04C03)

9

**ANHANG ZUM EUROPÄISCHEN RECHERCHENBERICHT**
**ÜBER DIE EUROPÄISCHE PATENTANMELDUNG NR.**                    EP 12 18 0971

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-02-2013

| Im Recherchenbericht angeführtes Patentdokument | Datum der Veröffentlichung | Mitglied(er) der Patentfamilie | Datum der Veröffentlichung |
|---|---|---|---|
| DE 10147946 A1 | 30-04-2003 | KEINE | |
| US 2009312999 A1 | 17-12-2009 | AU 2009260382 A1 | 23-12-2009 |
| | | CA 2726819 A1 | 23-12-2009 |
| | | CN 102067049 A | 18-05-2011 |
| | | EP 2300885 A1 | 30-03-2011 |
| | | JP 2011524591 A | 01-09-2011 |
| | | KR 20110020830 A | 03-03-2011 |
| | | US 2009312999 A1 | 17-12-2009 |
| | | WO 2009155149 A1 | 23-12-2009 |
| DE 19852080 C1 | 17-08-2000 | KEINE | |
| DE 102008056846 A1 | 04-06-2009 | DE 102008056846 A1 | 04-06-2009 |
| | | US 2009129432 A1 | 21-05-2009 |

EPO FORM P0461

Für nähere Einzelheiten zu diesem Anhang : siehe Amtsblatt des Europäischen Patentamts, Nr.12/82